# EUROPÄISCHE PATENTSCHRIFT

(11) **EP 1 873 543 B1**
(45) Veröffentlichungstag und Bekanntmachung des Hinweises auf die Patenterteilung: **15.09.2010**
(21) Anmeldenummer: 06013699.1
(22) Anmeldetag: 01.07.2006
(51) Int. Cl.: G01R 33/02

(54) **Magnetfeldkompensationssystem mit erhöhter Bandbreite**
Magnetic field compensation system with increased bandwidth
Système de compensation de champ magnétique avec largeur de bande accrue

(43) Veröffentlichungstag der Anmeldung: 02.01.2008
(73) Patentinhaber: Integrated Dynamics Engineering GmbH, 65479 Raunheim (DE)
(72) Erfinder: Heiland, Peter, 65479 Raunheim (DE)
(74) Vertreter: Herden, Andreas F.

(56) Entgegenhaltungen:
- DE-A1- 10 062 292
- GUTTMAN J L ET AL: "Measurement instrumentation for transient magnetic fields and currents" 2001 IEEE INTERNATIONAL SYMPOSIUM ON ELECTROMAGNETIC COMPATIBILITY. EMC. SYMPOSIUM RECORD. MONTREAL, CANADA, AUG. 13 - 17, 2001, INTERNATIONL SYMPOSIUM ON ELECTROMAGNETIC COMPATIBILITY, NEW YORK, NY : IEEE, US, Bd. VOL. 1 OF 2, 13. August 2001 (2001-08-13), Seiten 419-424, XP010557510 ISBN: 0-7803-6569-0

## Beschreibung

### Gebiet der Erfindung

Die Erfindung betrifft eine Einrichtung zu Messung eines Magnetfeldes sowie eine Einrichtung zur Magnetfeldkompensation. Weiter ist ein Verfahren zur Magnetfeldkompensation Gegenstand der Erfindung.

### Hintergrund der Erfindung

Einrichtungen zur Messung eines Magnetfeldes sind bekannt.

Moderne Sensoren zur Messung von magnetischen Feldern sind häufig als Fluxgate-Magnetometer ausgestaltet. So gibt es beispielsweise zwei- oder drei-Achsen Fluxgate-Magnetfeldsensoren, die Magnetfelder in alle Raumrichtungen messen können. Dabei befinden sich auf zwei ferromagnetischen Kernen jeweils drei Spulen. Ein Dreiecksgenerator erzeugt einen Strom, der durch die Anregungsspulen fließt. Durch den Strom wird in den ferromagnetischen Kernen ein Magnetfeld aufgebaut. Die Veränderung des magnetischen Flusses induziert in die sogenannten Pickup-Spulen Spannungen. Wenn kein externes Feld anliegt, ist die Differenz der Spannungen der Pickup-Spulen null. Sobald ein externes magnetisches Feld aufgebaut wird, entsteht eine Differenzspannung.

Diese Differenzspannung wird bei einem Magnetfeldkompensationssystem verwendet, um Kompensationsspulen anzusteuern. Das Magnetfeld der Kompensationsspulen, welche typischerweise in Vorrichtungen zur Magnetfeldkompensation als Helmholtz-Spulen ausgestaltet sind, kompensiert das externe Magnetfeld.

Derartige Fluxgate-Sensoren zeichnen sich durch eine hohe Empfindlichkeit und eine hohe Auflösung aus.

Nachteilig an Vorrichtungen zur Magnetfeldkompensation mit einem Fluxgate-Sensor ist, dass die Sensoren in aller Regel eine recht geringe Bandbreite haben. So reicht die Sensorbandbreite zumeist nicht über 2 kHz.

Alternativ kann als Sensor zur Messung des Magnetfeldes auch eine Spule verwendet werden und die durch ein externes Magnetfeld in die Spule induzierte Spannung gemessen werden. Derartige Spulensensoren eignen sich insbesondere für höhere Frequenzen, also für magnetische Wechselfelder und sind dagegen für Frequenzen unter 10 Hz zumeist ungeeignet. Darüber hinaus ist das Signal eines solchen Spulensensors nur sehr schlecht in eine digitale Signalverarbeitung zu integrieren. Aufgrund der hohen Frequenz der gemessenen Wechselfelder müsste eine digitale Digitalverarbeitung mit äußerst hoher Sample-Frequenz bereitgestellt werden, was aufwändig und in vielen Fällen nicht möglich ist.

Eine Messanordnung zur Erfassung von Magnetfeldern, welche eine Parallelschaltung eines Niederfrequenz-Messsystems und eines Hochfrequenz-Messsystems umfasst, ist aus der DE 100 62 292 A1 und aus Guttmann J.L. et al.: "Measurement Instrumentation for Transient Magnetic Fields and Currents", 2001 IEEE, Symposium on Electromagnetic Compatibility, Vol. 1, Seiten 419-424, bekannt.

### Aufgabe der Erfindung

Der Erfindung liegt demgegenüber die Aufgabe zugrunde, eine Einrichtung zur Messung eines Magnetfeldes bereitzustellen, welche eine hohe Bandbreite aufweist.

Insbesondere ist Aufgabe der Erfindung, eine Einrichtung zur Magnetfeldmessung bereitzustellen, welche bereits für Magnetfelder mit sehr niedriger Wechselfrequenz oder sogar mit einer Frequenz von nahezu 0 Hz geeignet ist.

Eine weitere Aufgabe der Erfindung ist es, eine Einrichtung zur Messung eines Magnetfeldes sowie eine Einrichtung zur Kompensation eines Magnetfeldes bereitzustellen, welche eine digitale Ansteuerung ermöglicht und zugleich auch für höherfrequente magnetische Wechselfelder, insbesondere auch für Wechselfelder über 2 kHz geeignet ist.

Weiter ist Aufgabe der Erfindung, eine besonders kompakte Sensorik zur Magnetfeldmessung bereitzustellen, insbesondere soll die gesamte Sensorik in einem Gehäuse integrierbar sein.

### Zusammenfassung der Erfindung

Die Aufgabe Erfindung wird durch eine Einrichtung zur Messung eines Magnetfeldes, eine Einrichtung zur Magnetfeldkompensation sowie durch ein Verfahren zur Magnetfeldkompensation nach einem der unabhängigen Ansprüche gelöst.

Bevorzugte Ausführungsformen und Weiterbildungen der Erfindung sind den jeweiligen Unteransprüchen zu entnehmen.

Danach ist eine Einrichtung zur Messung eines Magnetfeldes gemäß Anspruch 1 vorgesehen, welche einen ersten Sensor und einen zweiten Sensor umfasst. Der erste Sensor ist für Magnetfelder in einem ersten Frequenzbereich wirksam, dessen Frequenzbereich niedrigere Frequenzen umfasst als der Frequenzbereich, in welchem der zweite Sensor wirksam ist.

Durch die Kopplung derartiger Sensoren, welche in verschiedenen Frequenzbereichen wirksam sind, ist es möglich, eine Einrichtung zur Messung eines Magnetfeldes mit außerordentlich hoher Bandbreite bereitzustellen.

Bei einer bevorzugten Ausführungsform der Erfindung reicht die Bandbreite der Einrichtung zur Messung des Magnetfeldes von 5 Hz bis 1 kHz, vorzugsweise von 2 Hz bis 10 Hz und besonders bevorzugt von 0,1 Hz bis 20 kHz. Es werden also Einrichtungen zur Magnetfeldmessung realisiert, welche von einer Frequenz gleich oder nahezu 0 bis hin zu Wechselfrequenzen des Magnetfeldes von 20 kHz wirksam sind.

Vorzugsweise liegt der erste Frequenzbereich unter 15 kHz, bevorzugt unter 7 kHz und besonders bevorzugt unter 3 kHz, gleichzeitig beginnt der erste Frequenzbereich unterhalb 1 Hz, vorzugsweise unterhalb 0,5 Hz und besonders bevorzugt bei 0 Hz.

Der zweite Frequenzbereich liegt über 5 Hz, vorzugsweise über 15 Hz und besonders bevorzugt über 20 Hz und reicht mindestens bis 10 kHz, vorzugsweise bis 15 kHz und besonders bevorzugt bis mindestens 20 kHz.

Erfindungsgemäß weist die Einrichtung zur Messung des Magnetfeldes Mittel zur digitalen Verarbeitung des Signals des ersten Sensors und Mittel zur analogen Verarbeitung des zweiten Signals des zweiten Sensors auf.

Über eine digitale Verarbeitung der Sensorsignale des ersten Sensors lässt sich besonders eine leichte Ansteuerung der Einrichtung zur Messung des Magnetfeldes etwa über einen Computer erreichen. Vorzugsweise wird das Signal des zweiten Sensors analog verarbeitet, beispielsweise an einen anlogen Verstärker weitergegeben. So ist keine digitale Signalverarbeitung mit hoher Bandbreite notwendig und es können insgesamt höhere Bandbreiten der Einrichtung zur Messung des Magnetfeldes erreicht werden.

Die analoge Verarbeitung des Signals des zweiten Sensors schließt nicht aus, dass über die digitale Verarbeitung des Signals des ersten Sensors die analoge Verarbeitung beeinflusst werden kann, beispielsweise dass über eine digitale Steuer- und/oder Regeleinheit der Verstärkungsfaktor eines innerhalb der analogen Regelschleife angeordneten Verstärkers gesteuert und/oder geregelt werden kann.

Bei einer bevorzugten Ausführungsform der Erfindung liegen die Achsen, in denen die Sensoren wirksam sind, im Wesentlichen parallel. Vorzugsweise liegen die Achsen im Wesentlichen aufeinander. Durch eine Übereinstimmung der Achsen messen die Sensoren in die gleiche Richtung. So wird erreicht, dass die Signale der beiden Sensoren bei entsprechender Signalaufbereitung fließend ineinander übergehen.

Möglichst liegen die Sensoren nahe beieinander, insbesondere in einem Abstand von weniger als 10 cm, vorzugsweise weniger als 2 cm.

Bei einer Weiterbildung der Erfindung weist die Einrichtung zur Messung eines Magnetfeldes einen Tiefpass für das Signal des ersten Sensors auf. Mittels des Tiefpasses werden hohe Frequenzanteile abgeschnitten und so die Bandbreite des Sensors beschränkt. Gleichzeitig weist die Einrichtung zur Messung eines Magnetfeldes einen Hochpass für das Signal des zweiten Sensors auf, wobei mittels des Hochpasses die tiefen Frequenzanteile des zweiten Sensors abgeschnitten werden.

Durch gleichzeitigen Einsatz von Hochpass und Tiefpass wird erreicht, dass es keinen Frequenzbereich gibt, innerhalb dessen sich die Sensorsignale überschneiden. Die Grenzfrequenz, bei der von einem auf den anderen Sensor übergeben wird, liegt vorzugsweise zwischen 15 und 50 Hz.

Für die Messung von Magnetfeldern mit niedriger Wechselfrequenz wird vorzugsweise ein Fluxgate-Sensor verwendet. Derartige Fluxgate-Sensoren zeichnen sich durch Ansprechen bereits bei reinen DC-Feldern (0 Hz) aus, sind sehr empfindlich und haben eine hohe Genauigkeit.

Als zweiter Sensor kann eine Spule verwendet werden, bei welcher die in die Spule induzierte Spannung gemessen wird.

Um ein Übersprechen zwischen den beiden Sensoren möglichst gering zu halten, wird der Fluxgate-Sensor bei einer Weiterbildung der Erfindung mit einer Chopper-Frequenz betrieben, welche mindestens doppelt, vorzugsweise mindestens dreimal und besonders bevorzugt mindestens fünfmal so hoch ist, wie das obere Ende der Bandbreite, innerhalb deren die Einrichtung zur Messung des Magnetfeldes wirksam ist. Unter Chopper-Frequenz wird die Frequenz verstanden, mit welcher die Anregungsspulen des Fluxgate-Sensors betrieben werden. Dadurch, dass der Fluxgate-Sensor mit einer Frequenz betrieben wird, welche weit oberhalb der Bandbreite liegt, in welcher die Einrichtung zur Messung eines Magnetfeldes wirksam ist, wird ein Übersprechen zwischen den Sensoren minimiert.

Die Chopper-Frequenz liegt über 50 kHz, bevorzugt über 80 kHz und besonders bevorzugt über 120 kHz.

Um das Übersprechen weiter zu minimieren, werden die Sensoren so eingebaut, dass von den Sensoren ausgehende Magnetfeldemissionen möglichst im Wesentlichen vom jeweils anderen Sensor weg zeigen.

So ist es möglich, beide Sensoren in einem Gehäuse anzuordnen, und auf diese Weise einen Hybrid-Sensor bereitzustellen, der eine Bandbreite von 0 bis 20 kHz aufweist.

In dem Gehäuse oder in einer nachgeschalteten Verarbeitungseinrichtung können die Sensorsignale in einem Addierer zusammengeführt werden. Vor dem Addierer sind vorzugsweise ein Hochpass und ein Tiefpass angeordnet, so dass der Addierer im Wesentlichen die Funktion hat, die Sensorsignale auf eine Leitung zu schalten.

Die Erfindung betrifft des Weiteren eine Einrichtung zur Magnetfeldkompensation, welche eine Einrichtung zur Messung eines Magnetfeldes und zumindest eine Kompensationsspule umfasst.

Die Kompensationsspulen sind typischerweise als Helmholtz-Spulen ausgestaltet. Vorzugsweise werden drei im Wesentlichen senkrecht zueinander stehende Helmholtz-Spulen verwendet, so dass eine Magnetfeldkompensation in alle drei Raumrichtungen möglich ist.

Bei einer Weiterbildung der Erfindung umfasst die Einrichtung zur Magnetfeldkompensation zumindest einen digitalen Signalprozessor. Der digitale Signalprozessor ist vorzugsweise über einen Analog-Digitalwandler mit dem ersten Sensor verbunden. So wird das Signal des ersten Sensors in dem digitalen Signalprozessor weiter verarbeitet. Insbesondere kann das Signal verstärkt werden oder ein digitaler Tiefpass durch den digitalen Signalprozessor gebildet werden.

Der digitale Signalprozessor verfügt vorzugsweise über eine Schnittstelle zum Anschluss beispielsweise eines PC's, über die die Einrichtung zur Magnetfeldkompensation steuer-und/oder regelbar ist.

Über einen Digital-Analogwandler kann dann das Sensorsignal am Ausgang des digitalen Signalprozessors weitergegeben werden und als Signal zum Betrieb der Kompensationsspulen verwendet werden.

Um über den digitalen Signalprozessor auch die analoge Regelschleife kontrollieren zu können, welche vorzugsweise den zweiten Sensor umfasst, ist der digitale Signalprozessor bei einer Weiterbildung der Erfindung mit dem Gain eines Verstärkers verbunden. Über das Gain kann der Verstärkungsfaktor der analogen Signalschleife gesteuert und/oder geregelt werden.

Weiter kann der digitale Signalprozessor auch mit weiteren Komponenten der analogen Regelschleife verbunden sein, entweder um Signale der analogen Regelschleife bei der Steuerung oder Regelung zu berücksichtigen, um die Signale anzuzeigen und/oder um aktiv auf die analoge Regelschleife Einfluss zu nehmen. Insbesondere kann der digitale Signalprozessor auch Signale des zweiten Sensors empfangen und auswerten oder mit einem weiteren Verstärker verbunden sein, der als Abschlussverstärker die Kompensationssignale für die Helmholtz-Spulen verstärkt.

Schließlich betrifft die Erfindung ein Verfahren zur Magnetfeldkompensation gemäß Anspruch 21.

So wird ein Verfahren bereitgestellt, welches eine Magnetfeldkompensation mit äußerst hoher Bandbreite ermöglicht. Gleichzeitig ist eine digitale Steuerung oder Regelung möglich, ohne dass eine Digitalregelung mit hoher Sample-Frequenz bereitgestellt werden muss.

### Kurzbeschreibung der Zeichnungen

Die Erfindung soll im Folgenden anhand der Zeichnungen Fig. 1 bis Fig. 5 näher erläutert werden.
- Fig. 1: zeigt schematisch das Prinzip der Magnetfeldkompensation,
- Fig. 2: zeigt die Kennlinie eines Fluxgate-Sensors,
- Fig. 3: zeigt die Kennlinie einer Spule,
- Fig. 4: zeigt schematisch die Bestandteile eines Ausführungsbeispiels für ein System zur Magnetfeldkompensation,
- Fig. 5: zeigt schematisch die Verfahrensschritte eines Ausführungsbeispiels zur Magnetfeldkompensation.

### Detaillierte Beschreibung der Zeichnungen

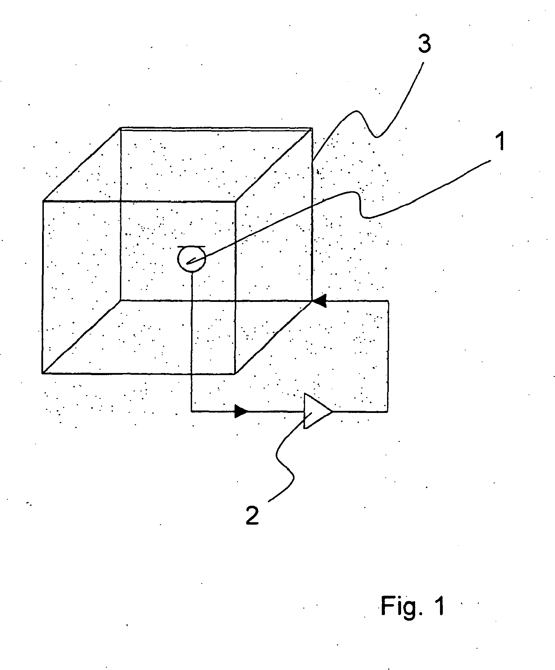

Bezug nehmend auf Fig. 1 soll das Prinzip der Magnetfeldkompensation erläutert werden. Über einen Sensor 1, welcher vorzugsweise in allen drei Raumrichtungen wirksam ist, wird das Magnetfeld gemessen. Der Sensor 1 ist über eine Regelstrecke mit Helmholtz-Spulen 3 verbunden, innerhalb der über einen Verstärker 2 das Sensorsignal verstärkt wird und drei senkrecht zueinander angeordnete Helmholtz-Spulen 3 angesteuert werden. Über die Helmholtz-Spulen 3 wird ein Kompensationsfeld erzeugt und idealerweise das Gesamtmagnetfeld an der Stelle des Sensors 1 auf 0 geregelt.

Bei der Kompensation der Magnetfelder spielt der Sensor die wichtigste Rolle. Die Störfelder können Frequenzen angefangen von einem reinen DC-Feld (0 Hz) bis hin zu einigen kHz annehmen. Der Sensor sollte daher in der Lage sein, Störfelder in einer breiten Bandbreite zu erfassen. Gleichzeitig muss die Regelstrecke, über die der Sensor gekoppelt ist, in der Lage sein, sowohl niedrig- als auch hochfrequente Signalanteile zu verarbeiten und daraus Kompensationssignale zu generieren.

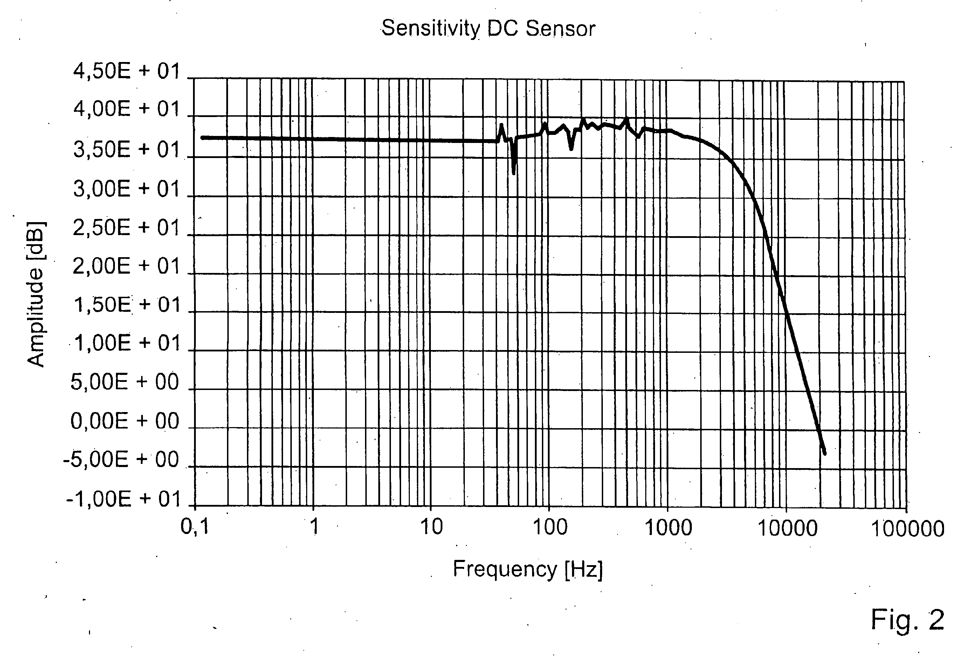

Fig. 2 zeigt eine Kennlinie eines Fluxgate-Sensors. Auf der X-Achse ist die Frequenz des Magnetfeldes in Hz und auf der Y-Achse die Signalamplitude des Sensors aufgetragen. Wie man der Kurve entnehmen kann, spricht der Fluxgate-Sensor bereits bei Feldern von nahezu 0 Hz an. Bei etwa 2 kHz fällt das Signal des Sensors steil ab. Ein derartiger Sensor ist also in der Lage, Wechselfelder bis höchstens 2 kHz zu bestimmen. Der Sensor zeichnet sich durch eine große Empfindlichkeit und hohe Genauigkeit aus.

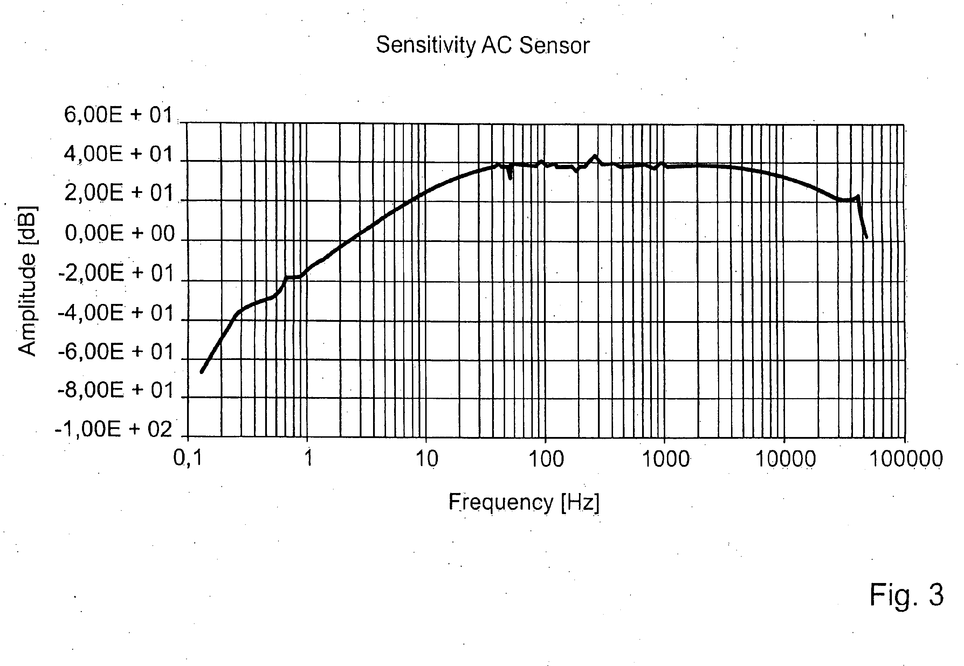

Fig. 3 zeigt die Kennlinie eines Sensors, der als Induktionsspule ausgebildet ist. Bei dieser Art von Sensor ist erst ab etwa 20 Hz ein Signal vorhanden, welches eine genaue Bestimmung des Magnetfeldes ermöglicht. Unterhalb von 20 Hz ist das Sensorsignal so schwach, dass es zur Magnetfeldkompensation nicht oder nur unzureichend verwendet werden kann.

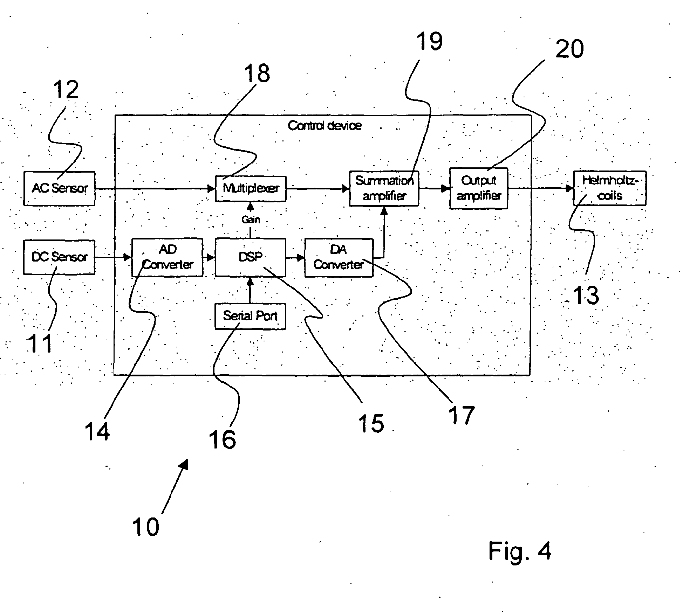

Bezug nehmend auf Fig. 4 sollen die wesentlichen Bestandteile eines Ausführungsbeispiels einer Einrichtung zur Magnetfeldkompensation 10 näher erläutert werden.

Die Einrichtung zur Magnetfeldkompensation 10 umfasst zwei Sensoren, einen ersten Sensor 11, welcher als Fluxgate-Sensor ausgebildet ist und niederfrequente Frequenzanteile, insbesondere im Bereich von 0 bis 20 Hz detektiert. Ein derartiger Sensor wird auch als DC-Sensor bezeichnet, auch wenn er zur Detektion von Magnetfeldern oberhalb von 0 Hz ausgebildet ist. Zur Erfassung von höherfrequenten Magnetfeldern, insbesondere von Magnetfeldanteilen über 20 Hz, umfasst die Einrichtung zur Magnetfeldkompensation 12 einen zweiten Sensor 12, der als Induktionsspule ausgebildet ist. Dieser wird auch als AC-Sensor bezeichnet.

Gewissermaßen den Kern der Einrichtung zur Magnetfeldkompensation 10 bildet ein digitaler Signalprozessor 15, über welchen eine digitale Regelstrecke zur Verarbeitung des Signals des ersten Sensors 11 gebildet wird. Der digitale Signalprozessor ist über eine serielle Schnittstelle 16 an einen Personalcomputer (nicht dargestellt) anschließbar.

Um die Signale des ersten Sensors 11 verarbeiten zu können, werden diese über einen Analog-Digital-Wandler 14 an den digitalen Signalprozessor 15 weitergegeben. Der digitale Signalprozessor 15 filtert in diesem Ausführungsbeispiel Frequenzanteile von über 20 Hz heraus und bildet so einen digitalen Tiefpass. Über die serielle Schnittstelle 16 kann die Grenzfrequenz des digitalen Tiefpasses eingestellt werden. Auch kann das Signal des ersten Sensors 11 verstärkt werden und der Verstärkungsfaktor ebenfalls über die serielle Schnittstelle 16 eingestellt werden. Das verarbeitet Signal wird an einen Digital-Analog-Wandler 17 weitergegeben.

Der zweite Sensor 12 ist mit einem Multiplexer 18 verbunden, welcher in diesem Ausführungsbeispiel im Wesentlichen als Verstärker eingesetzt wird. Das Gain des Multiplexers 18 ist mit dem digitalen Signalprozessor 15 verbunden. So kann der Verstärkungsfaktor für das Signal des zweiten Sensors 12 ebenfalls eingestellt werden. Vor dem Multiplexer 18 befindet sich noch ein Hochpass, der Frequenzanteile unter 20 Hz herausfiltert (nicht dargestellt). Die Signale des zweiten Sensors 12 durchlaufen nicht die digitale Regelstrecke, sondern werden analog an einen Addierer 19 weitergeleitet, der gleichfalls mit dem Digital-Analog-Wandler 17 verbunden ist.

Durch den Addierer 19 werden die Signale auf eine Leitung geschaltet und schließlich an einen weiteren Verstärker 20 weitergeleitet, über welchen das Kompensationssignal für die Helmholtz-Spulen 13 zur Magnetfeldkompensation verstärkt wird.

Das hier dargestellte System zur Magnetfeldkompensation 10 hat eine Regelbandbreite von 0 bis 20 kHz.

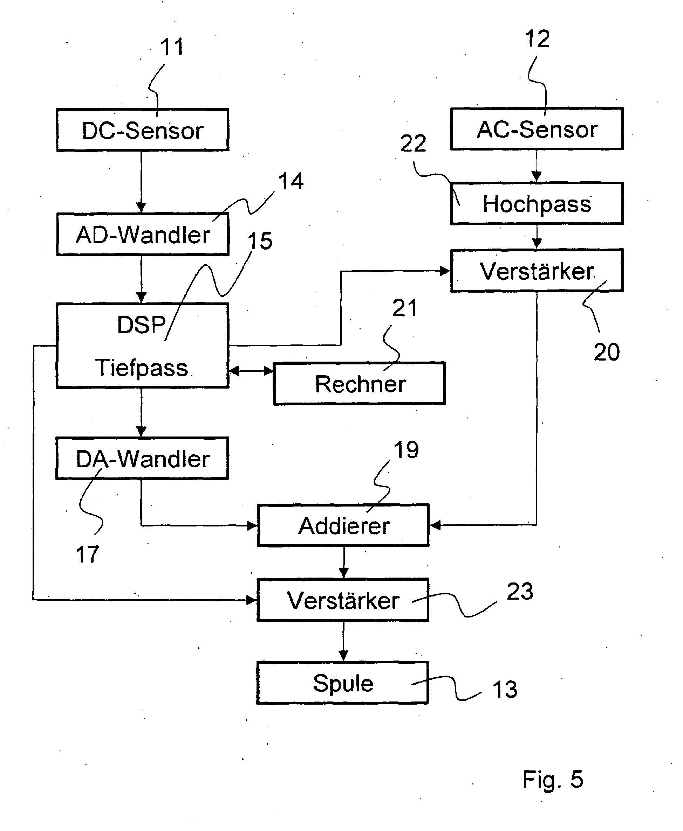

Bezug nehmend auf Fig. 5 sollen die wesentlichen Verfahrensschritte eines Ausführungsbeispiels eines erfindungsgemäßen Verfahrens zur Magnetfeldkompensation näher erläutert werden.

Über einen ersten Sensor 11 werden Frequenzanteile des magnetischen Feldes zwischen 0 und 20 Hz detektiert und an einen Analog-Digital-Wandler 14 weitergegeben. Der Analog-Digital-Wandler ist mit einem digitalen Signalprozessor 15 verbunden, welcher mit einem Rechner 21 verbunden ist und einen Tiefpass bildet. Der digitale Signalprozessor 15 verarbeitet die Sensorsignale. Die Verstärkungskennlinien können über den Rechner 21 eingestellt werden. Nach Verarbeitung wird das Signal des ersten Sensors 11 über einen Digital-Analog-Wandler 17 wieder in ein Analogsignal umgewandelt.

Ein zweiter Sensor 12 ist einer analogen Regelstrecke zugeordnet. Das Signal durchläuft zunächst einen Hochpass 22, um dann an einen Verstärker 20 weitergeleitet zu werden. Das Gain des Verstärkers 20 ist mit dem digitalen Signalprozessor verbunden. So kann über den digitalen Signalprozessor 15 der Verstärkungsfaktor kontrolliert werden. Das verstärkte Signal wird an einen Addierer 19 weitergegeben, wo es zu dem verarbeiteten Signal des ersten Sensors 11 addiert wird.

Über einen Verstärker 23 werden die Kompensationssignale für die Spule 13 nochmals verstärkt.

Der digitale Signalprozessor 15 ist auch mit dem Gain des Verstärkers 23 verbunden. So kann auch der Verstärkungsfaktor des Verstärkers 23 über den Rechner 21 kontrolliert werden.

### Bezugszeichenliste

- 1: Sensor
- 2: Verstärker
- 3: Helmholtz-Spule
- 10: Einrichtung zur Magnetfeldkompensation
- 11: erster Sensor
- 12: zweiter Sensor
- 13: Helmholtz-Spule
- 14: Analog-Digital-Wandler
- 15: digitaler Signalprozessor
- 16: serielle Schnittstelle
- 17: Digital-Analog-Wandler
- 18: Multiplexer
- 19: Addierer
- 20: Verstärker
- 21: Rechner
- 22: Hochpass
- 23: Verstärker

## Patentansprüche

1. Einrichtung zur Messung eines Magnetfeldes, umfassend einen ersten Sensor (11), welcher für Magnetfelder in einem ersten Frequenzbereich wirksam ist,
und zumindest einen zweiten Sensor (12), welcher für Magnetfelder in einem zweiten Frequenzbereich, der zumindest abschnittsweise über dem ersten Frequenzbereich liegt, wirksam ist, wobei die Einrichtung zur Messung eines Magnetfeldes Mittel zur digitalen Verarbeitung des Signals des ersten sensors (11) aufweist, **dadurch gekennzeichnet, dass** die Einrichtung zur Messung eines Magnetfeldes Mittel zur analogen Verarbeitung des Signals des zweiten Sensors (12) aufweist.

2. Einrichtung zur Messung eines Magnetfeldes nach Anspruch 1, **dadurch gekennzeichnet, dass** die Einrichtung zur Messung eines Magnetfeldes in einer Bandbreite von 5 Hz bis 1 kHz, vorzugsweise von 2 Hz bis 10 kHz, besonders bevorzugt von 0,1 Hz bis 20 kHz wirksam ist.

3. Einrichtung zur Messung eines Magnetfeldes nach einem der vorstehenden Ansprüche, **dadurch gekennzeichnet, dass** zumindest eine Achse, vorzugsweise alle Achsen, in denen die Sensoren wirksam sind, im wesentlichen parallel, insbesondere im Wesentlichem aufeinander liegen.

4. Einrichtung zur Messung eines Magnetfeldes nach einem der vorstehenden Ansprüche, **dadurch gekennzeichnet, dass** die Einrichtung zur Messung eines Magnetfeldes einen Tiefpass (15) für das Signal des ersten Sensors (11) umfasst.

5. Einrichtung zur Messung eines Magnetfeldes nach dem vorstehenden Anspruch, **dadurch gekennzeichnet, dass** die Grenzfrequenz des Tiefpasses unterhalb von 500 Hz, vorzugsweise unterhalb 100 Hz, besonders bevorzugt unterhalb 50 Hz liegt.

6. Einrichtung zur Messung eines Magnetfeldes nach einem der vorstehenden Ansprüche, **dadurch gekennzeichnet, dass** die Einrichtung zur Messung eines Magnetfeldes einen Hochpass (22) für das Signal des zweiten Sensors (12) umfasst.

7. Einrichtung zur Messung eines Magnetfeldes nach dem vorstehenden Anspruch, **dadurch gekennzeichnet, dass** die Grenzfrequenz des Hochpasses oberhalb 5 Hz, bevorzugt oberhalb 10 Hz, besonders bevorzugt oberhalb 15 Hz liegt.

8. Einrichtung zur Messung eines Magnetfeldes nach einem der vorstehenden Ansprüche, **dadurch gekennzeichnet, dass** es sich bei dem ersten Sensor (11) um einen Fluxgate-Sensor handelt.

9. Einrichtung zur Messung eines Magnetfeldes nach dem vorstehenden Anspruch, **dadurch gekennzeichnet, dass** der Fluxgate-Sensor mit einer Chopper-Frenquenz betreibbar ist, welche mindestens doppelt, vorzugsweise mindestens dreimal, besonders bevorzugt mindestens fünfmal so hoch ist wie das obere Ende der Bandbreite, innerhalb deren die Einrichtung zur Messung eines Magnetfeldes wirksam ist.

10. Einrichtung zur Messung eines Magnetfeldes nach einem der vorstehenden beiden Ansprüche, **dadurch gekennzeichnet, dass** die Chopper-Frequenz über 50 kHz, bevorzugt über 80 kHz, besonders bevorzugt über 120 kHz liegt.

11. Einrichtung zur Messung eines Magnetfeldes nach einem der vorstehenden Ansprüche, **dadurch gekennzeichnet, dass** die Einrichtung Mittel (19) zur Addition eines Signals des ersten Sensors (11) mit einem Signal des zweiten Sensors (12) umfasst.

12. Einrichtung zur Messung eines Magnetfeldes nach einem der vorstehenden Ansprüche, **dadurch gekennzeichnet, dass** der erste Sensor (11) und der zweite Sensor (12) in einem Gehäuse angeordnet sind.

13. Einrichtung zur Magnetfeldkompensation, umfassend zumindest eine Einrichtung zur Messung eines Magnetfeldes nach einem der vorstehenden Ansprüche und zumindest eine Kompensationsspule (13).

14. Einrichtung zur Magnetfeldkompensation nach dem vorstehenden Anspruch, **dadurch gekennzeichnet, dass** die Einrichtung zur Magnetfeldkompensation zumindest einen digitalen Signalprozessor (15) umfasst.

15. Einrichtung zur Magnetfeldkompensation nach dem verstehenden Anspruch, **dadurch gekennzeichnet, dass** zumindest das Signal des ersten Sensors (11) über einen AD-Wandler (14) an den digitalen Signalprozessor (15) weitergebbar und durch den digitalen Signalprozessor (15) verarbeitbar ist.

16. Einrichtung zur Magnetfeldkompensation nach einem der Ansprüche 14-15, **dadurch gekennzeichnet, dass** die Einrichtung einen Addierer (19) zum Addieren eines Signals des ersten Sensors (11) mit einem Signal des zweiten Sensors (12), insbesondere einem verarbeiteten Signal, umfasst.

17. Einrichtung zur Magnetfeldkompensation nach einem der Ansprüche (14-16), **dadurch gekennzeichnet, dass** das Signal des ersten Sensors (11) von dem digitalen Signalprozessor (15) an den Addierer (19) weitergebbar ist.

18. Einrichtung zur Magnetfeldkompensation nach einem der Ansprüche 13-17, **dadurch gekennzeichnet, dass** die Einrichtung zur Magnetfeldkompensation einen Versterker (23) umfasst.

19. Einrichtung zur Magnetfeldkompensation nach dem vorstehenden Anspruch, **dadurch gekennzeichnet, dass** der Verstärker (23), insbesondere das Gain des Verstärkers, mit einem digitalen, Signalprozessor (15) verbunden ist.

20. Einrichtung zur Magnetfeldkompensation nach einem der Ansprüche 13-14, **dadurch gekennzeichnet, dass** die Einrichtung zur Magnetfeldkompensation einen digitalen Signalprozessor (15) mit einer Schnittstelle, insbesondere zum Anschluss einer Steuereinrichtung, umfasst.

21. Verfahren zur Magnetfeldkompensation umfassend die Schritte:
- Erfassen eines magnetischen Feldes in einem ersten Frequenzbereich mittels eines erstens Sensors (11)
- Erfassen eines magnetischen Feldes in einem zweiten Frequenzbereich, welcher zumindest abschnittsweise über dem ersten Frequenzbereich liegt, mittels eines zweiten Sensors (12),
- Verstärken der Sensorsignale,
- Ansteuern zumindest einer Kompensationsspule, wobei die Signale des ersten Sensors (11) digital und die Signale des zweiten Sensors (12) analog verarbeitet werden.

22. Verfahren zur Magnetfeldkompensation nach dem vorstehenden Anspruch, **dadurch gekennzeichnet, dass** die Signale des ersten sensors (11) mittels eines digitalen Signalprozessors, verarbeitet werden.

23. Verfahren zur Magnetfeldkompensation nach einem der Ansprüche 21-22, **dadurch gekennzeichnet, dass** mittels eines digitalen Signalprozessors (15) zumindest der Verstärkungsfaktor die Verstärkung des Signals des zweiten Sensors (12) gesteuert und/oder geregelt wird.

24. Verfahren zur Magnetfeldkompensation nach einem der Anprüche 21-23, **dadurch gekennzeichnet, dass** mittels eines digitalen Signalprozessor (15) ein digitaler Tiefpass für den ersten Sensor erzeugt wird.

## Claims

1. Device for measuring a magnetic field, comprising
a first sensor (11) which is effective for magnetic fields in a first frequency range, and at least one second sensor (12) which is effective for magnetic fields in a second frequency range, at least sections of which are above the first frequency range, wherein the device for measuring a magnetic field comprises means for digital processing of the signal of the signal of the first sensor (11), **characterised in that** the device for measuring a magnetic field comprises means for analogue processing of the signal of the second sensor (12).

2. Device for measuring a magnetic field as claimed in claim 1, **characterised in that** the device for measuring a magnetic field is effective in a bandwidth of 5 Hz to 1 kHz, preferably 2 Hz to 10 kHz, particularly preferably 0.1 to 20 kHz.

3. Device for measuring a magnetic field as claimed in any one of the preceding claims, **characterised in that** at least one axis, preferably all axes, in which the sensors are effective, lie substantially in parallel with one another, in particular substantially one on top of the other.

4. Device for measuring a magnetic field as claimed in any one of the preceding claims, **characterised in that** the device for measuring a magnetic field comprises a low-pass filter (15) for the signal from the first sensor (11).

5. Device for measuring a magnetic field as claimed in the preceding claim, **characterised in that** the limit frequency of the low-pass filter is below 500 Hz, preferably below 100 Hz, particularly preferably below 50 Hz.

6. Device for measuring a magnetic field as claimed in any one of the preceding claims, **characterised in that** the device for measuring a magnetic field comprises a high-pass filter (22) for the signal from the second sensor (12).

7. Device for measuring a magnetic field as claimed in the preceding claim, **characterised in that** the limit frequency of the high-pass filter is above 5 Hz, preferably above 10 Hz, particularly preferably above 15 Hz.

8. Device for measuring a magnetic field as claimed in any one of the preceding claims, **characterised in that** the first sensor (11) is a fluxgate sensor.

9. Device for measuring a magnetic field as claimed in the preceding claim, **characterised in that** the fluxgate sensor can be operated at a chopper frequency which is at least twice, preferably at least three-times, particularly preferably at least five-times, as high as the upper end of the bandwidth, within which the device for measuring a magnetic field is effective.

10. Device for measuring a magnetic field as claimed in any one of the preceding two claims, **characterised in that** the chopper frequency is above 50 kHz, preferably above 80 kHz, particularly preferably above 120 kHz.

11. Device for measuring a magnetic field as claimed in any one of the preceding claims, **characterised in that** the device comprises means (19) for adding a signal of the first sensor (11) to a signal of the second sensor (12).

12. Device for measuring a magnetic field as claimed in any one of the preceding claims, **characterised in that** the first sensor (11) and the second sensor (12) are disposed in a housing.

13. Device for magnetic field compensation, comprising at least one device for measuring a magnetic field as claimed in any one of the preceding claims and at least one compensation coil (13).

14. Device for magnetic field compensation as claimed in the preceding claim, **characterised in that** the device for magnetic field compensation comprises at least one digital signal processor (15).

15. Device for magnetic field compensation as claimed in the preceding claim, **characterised in that** at least the signal of the first sensor (11) can be relayed via an analogue digital converter (14) to the digital signal processor (15) and can be processed by the digital signal processor (15).

16. Device for magnetic field compensation as claimed in any one of claims 14-15, **characterised in that** the device comprises an adder (19) for adding a signal of the first sensor (11) to a signal of the second sensor (12), in particular a processed signal.

17. Device for magnetic field compensation as claimed in any one of claims 14-16, **characterised in that** the signal of the first sensor (11) can be relayed from the digital signal processor (15) to the adder (19).

18. Device for magnetic field compensation as claimed in any one of claims 13-17, **characterised in that** the device for magnetic field compensation comprises an amplifier (23).

19. Device for magnetic field compensation as claimed in the preceding claim, **characterised in that** the amplifier (23), in particular the gain of the amplifier, is connected to a digital signal processor (15).

20. Device for magnetic field compensation as claimed in any one of claims 13-19, **characterised in that** the device for magnetic field compensation comprises a digital signal processor (15) having an interface, in particular for connecting a control device.

21. Method for magnetic field compensation, comprising the steps of:
- detecting a magnetic field in a first frequency range by means of a first sensor (11),
- detecting a magnetic field in a second frequency range, at least sections of which are above the first frequency range, by means of a second sensor (12),
- amplifying the sensor signals,
- controlling at least one compensation coil, wherein the signals of the first sensor (11) are processed in a digital manner and the signals of the second sensor (12) are processed in an analogue manner.

22. Method for magnetic field compensation as claimed in the preceding claim, **characterised in that** the signals of the first sensor (11) are processed by means of a digital signal processor.

23. Method for magnetic field compensation as claimed in any one of claims 21-22, **characterised in that** at least the amplification factor the amplification of the signal of the second sensor (12) *[sic]* is controlled and/or regulated by means of a digital signal processor (15).

24. Method for magnetic field compensation as claimed in any one of claims 21-23, **characterised in that** a digital low-pass filter for the first sensor is produced by means of a digital signal processor (15).

## Revendications

1. Dispositif pour mesurer un champ magnétique, comprenant un premier capteur (11), qui est efficace pour des champs magnétiques dans une première plage de fréquences,
et au moins un second capteur (12), qui est efficace pour des champs magnétiques dans une seconde plage de fréquences, qui se situe au moins par endroits au-dessus de la première plage de fréquences, le dispositif pour mesurer un champ magnétique présentant des moyens pour le traitement numérique du signal du premier capteur (11), **caractérisé en ce que** le dispositif pour mesurer un champ magnétique présente des moyens pour le traitement analogique du signal du second capteur (12).

2. Dispositif pour mesurer un champ magnétique selon la revendication 1, **caractérisé en ce que** le dispositif pour mesurer un champ magnétique est efficace dans une largeur de bande de 5 Hz à 1 kHz, de préférence de 2 Hz à 10 kHz, de manière particulièrement préférée de 0,1 Hz à 20 kHz.

3. Dispositif pour mesurer un champ magnétique selon l'une quelconque des revendications précédentes, **caractérisé en ce qu'**au moins un axe, de préférence tous les axes, dans lesquels les capteurs sont efficaces, sont disposés de façon sensiblement parallèle, en particulier sensiblement les uns sur les autres.

4. Dispositif pour mesurer un champ magnétique selon l'une quelconque des revendications précédentes, **caractérisé en ce que** le dispositif pour mesurer un champ magnétique comporte un filtre passe-bas (15) pour le signal du premier capteur (11).

5. Dispositif pour mesurer un champ magnétique selon la revendication précédente, **caractérisé en ce que** la fréquence limite du filtre passe-bas se situe au-dessous de 500 Hz, de préférence au-dessous de 100 Hz, de manière particulièrement préférée au-dessous de 50 Hz.

6. Dispositif pour mesurer un champ magnétique selon l'une quelconque des revendications précédentes, **caractérisé en ce que** le dispositif pour mesurer un champ magnétique comporte un filtre passe-haut (22) pour le signal du second capteur (12).

7. Dispositif pour mesurer un champ magnétique selon la revendication précédente, **caractérisé en ce que** la fréquence limite du filtre passe-haut se situe au-dessus de 5 Hz, de préférence au-dessus de 10 Hz, de manière particulièrement préférée au-dessus de 15 Hz.

8. Dispositif pour mesurer un champ magnétique selon l'une quelconque des revendications précédentes, **caractérisé en ce que**, en ce qui concerne le premier capteur (11), il s'agit d'un capteur à fluxage.

9. Dispositif pour mesurer un champ magnétique selon la revendication précédente, **caractérisé en ce que** le capteur à fluxage peut être utilisé avec une fréquence de hacheur, qui est au moins deux fois, de préférence au moins trois fois, de manière particulièrement préférée au moins cinq fois supérieure à l'extrémité supérieure de la largeur de bande, à l'intérieur de laquelle le dispositif pour mesurer un champ magnétique est efficace.

10. Dispositif pour mesurer un champ magnétique selon l'une quelconque des revendications précédentes, **caractérisé en ce que** la fréquence de hacheur est supérieure à 50 Hz, de préférence à 80 kHz, de manière particulièrement préférée à 120 kHz.

11. Dispositif pour mesurer un champ magnétique selon l'une quelconque des revendications précédentes, **caractérisé en ce que** le dispositif comprend des moyens (19) pour le cumul d'un signal du premier capteur (11) avec un signal du second capteur (12).

12. Dispositif pour mesurer un champ magnétique selon l'une quelconque des revendications précédentes, **caractérisé en ce que** le premier capteur (11) et le second capteur (12) sont disposés dans un boîtier.

13. Dispositif pour la compensation du champ magnétique, comprenant au moins un dispositif pour mesurer un champ magnétique selon l'une quelconque des revendications précédentes et au moins une bobine de compensation (13).

14. Dispositif pour la compensation du champ magnétique selon la revendication précédente, **caractérisé en ce que** le dispositif pour la compensation du champ magnétique comprend au moins un processus de signaux numériques (15).

15. Dispositif pour la compensation du champ magnétique selon la revendication précédente, **caractérisé en ce qu'**au moins le signal du premier capteur (11) peut être retransmis au moins d'un convertisseur analogique-numérique (14) au processeur de signaux numériques (15) et peut être traité par le processeur de signaux numériques (15).

16. Dispositif pour la compensation du champ magnétique selon l'une des revendications 14-15, **caractérisé en ce que** le dispositif comprend un totalisateur (19) pour la totalisation d'un signal du premier capteur (11) avec un signal du second capteur (12), en particulier un signal traité.

17. Dispositif pour la compensation du champ magnétique selon l'une quelconque des revendications 14-16, **caractérisé en ce que** le signal du premier capteur (11) peut être retransmis par le processeur de signaux numériques (15) au totalisateur (19).

18. Dispositif pour la compensation du champ magnétique selon l'une quelconque des revendications 13-17, **caractérisé en ce que** le dispositif pour la compensation du champ magnétique comporte un amplificateur (23).

19. Dispositif pour la compensation du champ magnétique selon la revendication précédente, **caractérisé en ce que** l'amplificateur (23), en particulier le gain de l'amplificateur, est relié à un processeur de signaux numériques (15).

20. Dispositif pour la compensation du champ magnétique selon l'une quelconque des revendications 13-19, **caractérisé en ce que** le dispositif pour la compensation du champ magnétique comprend un processeur de signaux numériques (15) avec une interface, en particulier pour le raccordement d'un dispositif de commande.

21. Procédé pour la compensation du champ magnétique comprenant les étapes suivantes :
- enregistrement d'un champ magnétique dans une première plage de fréquences au moyen d'un premier capteur (11),
- enregistrement d'un champ magnétique dans une seconde plage de fréquences, qui se situe au moins par endroits au-dessus de la première plage de fréquences, au moyen d'un second capteur (12),
- amplification des signaux de capteur,
- excitation d'au moins une bobine de compensation, les signaux du premier capteur (11) étant traités de façon numérique et les signaux du second capteur (12) de façon analogique.

22. Procédé pour la compensation du champ magnétique selon la revendication précédente, **caractérisé en ce que** les signaux du premier capteur (11) sont traités au moyen d'un processeur de signaux numériques.

23. Procédé pour la compensation du champ magnétique selon l'une quelconque des revendications 21-22, **caractérisé en ce qu'**au moins le facteur d'amplification ou l'amplification du signal du second capteur (12) est commandé et/ou réglé au moyen d'un processeur de signaux numériques (15).

24. Procédé pour la compensation du champ magnétique selon l'une des revendications 21-23, **caractérisé en ce qu'**un filtre passe-bas numérique pour le premier capteur est généré au moyen d'un processeur de signaux numériques (15).
